# EUROPÄISCHE PATENTSCHRIFT

(11) **EP 1 037 286 B1**
(45) Veröffentlichungstag und Bekanntmachung des Hinweises auf die Patenterteilung: **24.01.2007**
(21) Anmeldenummer: 00104255.5
(22) Anmeldetag: 01.03.2000
(51) Int. Cl.: H01L 29/744, H01L 29/06, H01L 29/10

(54) **Symmetrischer Thyristor mit verringerter Dicke und Herstellungsverfahren dafür**
Symmetrical thyristor with reduced thickness and manufacturing method
Thyristor symétrique avec une épaisseur réduite et son procédé de fabrication

(30) Priorität: 02.03.1999 DE 19909105
(43) Veröffentlichungstag der Anmeldung: 20.09.2000
(73) Patentinhaber: Infineon Technologies AG, 81669 München (DE)
(72) Erfinder: Schulze, Hans-Joachim, Dr., 85521 Ottobrunn (DE); Reznik, Daniel, Dr., 80686 München (DE)
(74) Vertreter: Bickel, Michael

(56) Entgegenhaltungen:
- EP-A- 0 158 186
- EP-A- 0 344 514
- EP-A- 0 387 721
- EP-A- 0 405 200
- EP-A- 0 556 739
- DE-A- 1 917 013
- DE-A- 19 731 495
- JP-A- 62 290 179
- US-A- 3 855 611

## Beschreibung

Die Erfindung bezieht sich auf einen symmetrischen Thyristor mit verringerter Dicke und ein Verfahren zum Herstellen eines solchen. Insbesondere bezieht sich die Erfindung auf einen Thyristor entsprechend Anspruch 1 mit einer ersten Zone von einem ersten Leitfähigkeitstyp, die als Anode dient, einer zweiten Zone von einem zweiten Leitfähigkeitstyp, die als Basis dient, einer dritten Zone von dem ersten Leitfähigkeitstyp, einer vierten Zone von dem zweiten Leitfähigkeitstyp, die als Kathode dient, wobei die erste und die vierte Zone höher dotiert sind als die zweite bzw. dritte Zone und mindestens eine Steuerelektrode mit der dritten Zone verbunden ist.

Thyristoren müssen je nach Sperrfähigkeit eine Mindestdicke haben, die bei Thyristoren mit hoher Sperrfähigkeit sehr groß werden kann. Eine große Dicke des Bauelements hat den Nachteil, daß die Gesamtverlustleistung des Bauelements steigt. Damit steigen die Kosten für den Betrieb der Geräte und Vorrichtungen, in denen die Thyristoren eingesetzt werden, z.B. infolge von zusätzlichem Beschaltungsaufwand. Viele Anwender bevorzugen daher eine Serienschaltung mit mehreren niedersperrenden Thyristoren, um die Dicke der Einzelbauelemente und damit deren Verlustleistung so gering wie möglich zu halten. Die u.U. große Anzahl von hintereinander zu schaltenden, niedersperrenden Thyristoren, die einen Thyristor mit hoher Sperrleistung ersetzen sollen, beeinträchtigt aber die Zuverlässigkeit des Gesamtsystems.

Auch asymmetrische Thyristoren bieten hier keinen Ausweg. Die Dicke der asymmetrischen Thyristoren ist zwar deutlich geringer als bei symmetrischen Thyristoren. Asymmetrische Thyristoren sind jedoch nicht geeignet, wenn hohe Rücksperrfähigkeiten gefordert werden.

Die EP 0 387 721 A2 beschreibt entsprechend der Präambel des Anspruchs 1 einen Thyristor mit einer innerhalb einer Basisschicht angeordneten höher dotierten Teilschicht, die an eine externe Spannungsquelle angeschlossen ist, die dazu dient, bei Abschalten des Thyristors in der Basisschicht angesammelte Minoritätsladungsträger abzusaugen.

Die EP 0 344 514 B1 beschreibt einen Thyristor mit mehreren in einer Basisschicht angeordneten höher dotierten Halbleiterschichten.

Die EP 0 556 739 A1 beschreibt einen GTO-Thyristor mit einer Basiszone, in der zwischen einem ersten intrinsisch dotierten Abschnitt und einem zweiten höher dotierten Abschnitt eine dritte hochdotierte Halbleiterzone angeordnet ist.

Die EP 0 405 200 A1 beschreibt einen IGBT mit einer innerhalb einer Basisschicht angeordneten Rekombinationsschicht, die Öffnungen aufweist, um ein Durchgreifen eines elektrischen Feldes durch die Rekombinationsschicht hindurch zu ermöglichen.

Aufgabe der vorliegenden Erfindung ist es, einen symmetrischen Thyristor, der eine reduzierte statische und dynamische Verlustleistung hat, sowie ein Herstellungsverfahren für einen solchen anzugeben.

Die Aufgabe wird gelöst durch einen Thyristor mit den Eigenschaften nach Anspruch 1 und ein Herstellungsverfahren nach Anspruch 2. Bevorzugte Ausführungsformen der Erfindung sind Gegenstand der Unteransprüche.

Die Lösung der obigen Aufgabe beruht darauf, etwa in der halben Tiefe der Basis von symmetrisch sperrenden Thyristoren eine Feldstoppzone zu integrieren, die es erlaubt, Siliziumgrundmaterial mit möglichst niedriger Grunddotierung einzusetzen. Die Herstellung einer solchen Thyristorstruktur läßt sich besonders vorteilhaft mit einer Verbindung von zwei Wafern (Waferbonding) durchführen.

Der erfindungsgemäße Thyristor mit einer ersten Zone von einem ersten Leitfähigkeitstyp, die als Anode dient, einer zweiten Zone von einem zweiten Leitfähigkeitstyp, die als Basis dient, einer dritten Zone von dem ersten Leitfähigkeitstyp, einer vierten Zone von dem zweiten Leitfähigkeitstyp, die als Kathode dient, wobei die erste und die vierte Zone höher dotiert sind als die zweite bzw. dritte Zone und mindestens eine Steuerelektrode mit der dritten Zone verbunden ist, ist gekennzeichnet durch eine Feldstoppzone von dem zweiten Leitfähigkeitstyp, die annähernd in der Mitte der zweiten Zone angeordnet ist, so daß sie die zweite Zone in zwei im wesentlichen gleich große Abschnitte unterteilt.

Die Feldstoppzone ist stärker dotiert als die (sie umgebende) zweite Zone. Dabei ist die Feldstoppzone insbesondere so dotiert, daß ein Eindringen der Raumladungszone von einer Hälfte der n⁻-Basis in eine andere Hälfte der n⁻-Basis verhindert wird.

Das Verfahren zum Herstellen eines Thyristors mit den Schritten: Erzeugen einer ersten Zone von einem ersten Leitfähigkeitstyp, die als Anode dient, Erzeugen einer zweiten Zone von einem zweiten Leitfähigkeitstyp, die als Basis dient, Erzeugen einer dritten Zone von dem ersten Leitfähigkeitstyp, und Erzeugen einer vierten Zone von dem zweiten Leitfähigkeitstyp, die als Kathode dient, ist erfindungsgemäß dadurch gekennzeichnet, daß die erste Zone und ein erster Abschnitt der zweiten Zone auf einem ersten Wafer erzeugt werden, die dritte Zone und die vierte Zone sowie ein zweiter Abschnitt der zweiten Zone auf einem zweiten Wafer erzeugt werden, eine Feldstoppschicht in einem Bereich an einer inneren Oberfläche des ersten Wafers oder des zweiten Wafers erzeugt wird und der erste Wafer mit dem zweiten Wafer mittels dem sogenannten Waferbonding-Verfahren verbunden wird, so daß die beiden inneren Oberflächen der beiden Wafer aufeinander liegen.

Vorzugsweise erfolgt die Erzeugung der Feldstoppzone durch Ionenimplantation einer Schicht auf einer inneren Oberfläche eines der beiden Wafer, und die implantierten Atome werden durch eine nachfolgende Temperaturbehandlung elektrisch aktiviert und eventuell eindiffundiert. Die Ionenimplantation erfolgt bei der Herstellung insbesondere mit einer Ionendosis von 10¹²cm⁻² bis 10¹³cm⁻².

Ein Vorteil der sich durch die Feldstoppzone ergebenden Feldverteilung liegt darin, daß man auf die bei symmetrischen Thyristoren erforderliche zusätzliche neutrale Zone verzichten kann. Der Feldverlauf in der Basiszone wird auf einen Abschnitt der Basiszone beschränkt, so daß der andere Abschnitt der Basiszone eine neutrale Zone bildet, die erfindungsgemäß eine vertikale Ausdehnung von etwa der halben Dicke der Basiszone hat. Dies verringert den Teiltransistorverstärkungsfaktor αₚₙₚ gegenüber der herkömmlichen Dimensionierung deutlich und erhöht damit in demselben Maß die Sperrfähigkeit des Thyristors.

Weitere Vorteile und Merkmale der Erfindung ergeben sich aus der folgenden Beschreibung von Einzelheiten zeichnerisch dargestellter Ausführungsformen der Erfindung.

Fig. 1 zeigt den Aufbau einer Ausführungsform des erfindungsgemäßen symmetrischen Thyristors.

Fig. 2 zeigt den Feldverlauf in dem Thyristor nach Fig. 1.

Fig. 3 zeigt einen symmetrischen Thyristor nach dem Stand der Technik.

Fig. 4 zeigt den Feldverlauf in dem Thyristor nach Fig. 3.

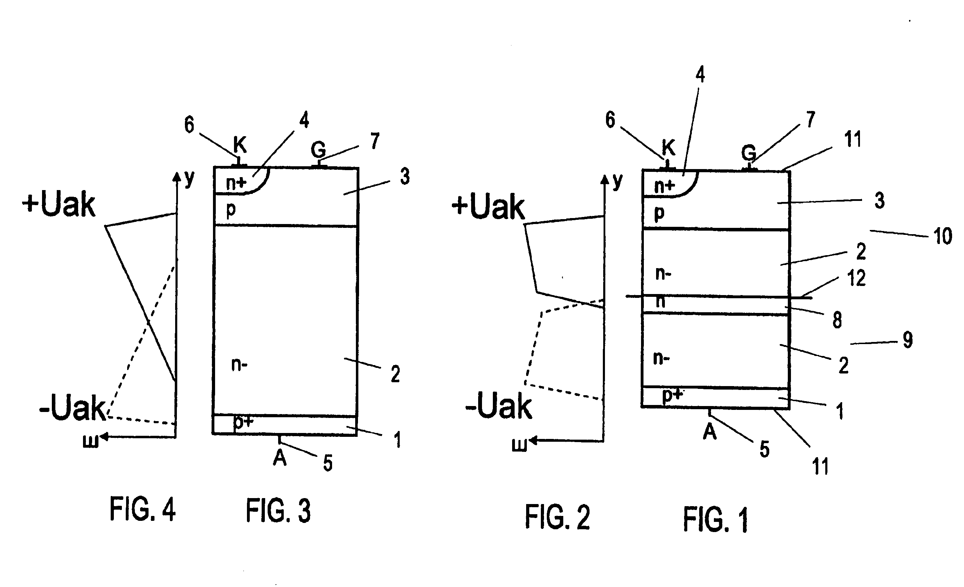

Ein Thyristor mit vier Schichten weist eine erste Zone 1 von einem ersten Leitfähigkeitstyp auf, die als Anode dient. In der gezeigten Ausführungsform ist die erste Zone 1 von dem ersten Leitfähigkeitstyp p-dotiert. An die erste Zone 1 schließt sich eine zweite Zone 2 an, die von einem zweiten Leitfähigkeitstyp ist. Die zweite Zone 2 dient als Basis des Thyristors. Der zweite Leitfähigkeitstyp ist dem ersten Leitfähigkeitstyp entgegengesetzt, so daß die zweite Zone 2 in der gezeigten Ausführungsform n-dotiert ist. Der zweiten Zone 2 folgt eine dritte Zone 3, die wiederum von dem ersten Leitfähigkeitstyp ist, d.h. die in der Ausführungsform nach Fig. 1 p-dotiert ist. Schließlich folgt auf die dritte Zone 3 eine vierte Zone 4, die von dem zweiten Leitfähigkeitstyp ist und als Kathode des Thyristors dient.

Es ergeben sich somit drei pn-Übergänge, nämlich zwischen der ersten und zweiten Zone 1 und 2, sowie zwischen der zweiten und der dritten Zone 2 und 3 und schließlich zwischen der dritten und der vierten Zone 3 und 4. Dabei ist die erste und die vierte Zone 1 bzw. 4 jeweils höher dotiert als die zweite und dritte Zone 2 bzw. 3.

Als Anschlüsse des Thyristors sind ein Anodenanschluß 5 an der ersten, p-dotierten Zone 1 und ein Kathodenanschluß 6 an der vierten, n-dotierten Zone 4 vorgesehen. Durch mindestens eine Steuerelektrode 7, die mit der dritten Zone 3 verbunden ist, wird das Zündverhalten des Thyristors gesteuert.

Da wie bereits oben beschrieben die Dicke von symmetrischen Thyristoren je nach Sperrfähigkeit sehr groß werden kann, steigt u.U. in demselben Maße die Gesamtverlustleistung des Bauelements. Um die statische und dynamische Verlustleistung eines symmetrischen Thyristors zu reduzieren, umfaßt der erfindungsgemäße Thyristor eine Feldstoppzone 8 von dem zweiten Leitfähigkeitstyp. Die Feldstoppzone 8 ist damit von demselben Leitfähigkeitstyp wie die sie umgebende zweite Zone 2, d.h. sie ist n-dotiert. Sie ist allerdings stärker dotiert als die zweite Zone 2: Während die zweite Zone 2 n⁻-dotiert ist, ist die Feldstoppzone 8 n-dotiert. Die Feldstopppzone 8 ist annähernd in der Mitte der zweiten Zone 2 angeordnet, so daß die zweite Zone 2 in zwei im wesentlichen gleich große, übereinander liegende Abschnitte unterteilt wird. Dadurch wird ein Feldverlauf in der zweiten Zone 2 einschließlich der Feldstoppzone 8 erreicht, der bei vorwärtssperrendem und rückwärtssperrendem Thyristor symmetrisch ist. Das bedeutet, daß die Sperrfähigkeit des Thyristors in Vorwärtsrichtung und in Rückwärtsrichtung annähernd gleich ist.

Der Feldverlauf in dem Thyristor ist in Fig. 2 für den vorwärtssperrenden wie auch den rückwärtssperrenden Thyristor gezeigt. In vertikaler Richtung ist die Entfernung von der Anode bzw. Kathode des Thyristors dargestellt, in horizontaler Richtung ist die Feldstärke in dem Thyristor dargestellt. Der Feldverlauf in Vorwärtsrichtung ist mit einer durchgezogenen Linie dargestellt, der Feldverlauf in Rückwärtsrichtung ist gestrichelt dargestellt. Wie Fig. 2 zu entnehmen ist, steigt das Feld innerhalb der n-dotierten Feldstoppzone 8 steil an, nimmt in einem Abschnitt der n⁻-dotierten Basiszone 2 weniger steil zu und fällt in der angrenzenden p- bzw. p⁺-Zone dann wieder steil ab. Die Dotierung der Feldstoppzone 8 wird dabei vorzugsweise so gewählt, daß sie gerade ausreicht, um ein Eindringen der Raumladungszone in die andere Hälfte der n⁻-Basis 2 zu verhindern.

Der Nutzen, den man aus dieser Feldverteilung ziehen kann, besteht darin, daß man auf die neutrale Zone verzichten kann, die bei symmetrischen Thyristoren zusätzlich vorgesehen werden muß, um bei hoher Spannung den sogenannten Punch-through-Effekt zu vermeiden. Da diese zusätzlich neutrale Zone eine Dicke von ca. 100 bis 150 µm erreichen kann, trägt sie wesentlich zu der unerwünschten Dicke des Bauelements bei.

Fig. 3 und Fig. 4 zeigen (nicht maßstabsgetreu) zum Vergleich den Aufbau und den vertikalen Feldverlauf in einem symmetrischen Thyristor bei herkömmlicher Dimensionierung. Dabei sind Komponenten, die identisch mit denen in Fig. 1 bzw. 2 sind, mit denselben Bezugszeichen versehen. Sie werden im folgenden nicht noch einmal erläutert.

Der Thyristor in Fig. 3 ist ähnlich wie der Thyristor in Fig. 1 aufgebaut, außer daß bei dem Thyristor in Fig. 3 die Feldstoppzone 8 fehlt, die ein wesentliches Merkmal der vorliegenden Erfindung ist.

Der in Fig. 4 gezeigte Feldverlauf dieses Thyristors weicht aufgrund der fehlenden Feldstoppzone 8 von dem Feldverlauf nach Fig. 2 in dem erfindungsgemäßen Thyristor ab. Während der Feldverlauf in Fig. 2 im wesentlichen trapezförmig ist, ist der Feldverlauf in Fig. 4 dreieckig: Das Feld steigt innerhalb der Basiszone 2 an, erreicht seinen Maximalwert an dem pn-Übergang zu der benachbarten p-Zone 1 oder 3 (je nachdem ob die anliegende Spannung größer oder kleiner als 0 ist) und fällt in der benachbarten p- bzw. p⁺-dotierten Zone steil ab. Wie Fig. 4 zu entnehmen ist, wird beim Stand der Technik für den Anstieg des Feldes in der Basiszone 2 nahezu die gesamte Zone 2 (bis auf die oben erwähnte neutrale Zone von ca. 100 bis 150 µm) beansprucht. Dagegen bleibt nach Fig. 2 bei dem erfindungsgemäßen Thyristor der Feldaufbau nur auf etwa die Hälfte der Basiszone 2 beschränkt. Die andere Hälfte der Basiszone 2 wirkt als neutrale Zone, um bei hoher Spannung den sogenannten Punch-through-Effekt zu vermeiden. Damit wird im Sperrfall durch die erhöhte Rekombination in der dickeren neutralen Zone (üblicherweise wird bei Thyristoren die Trägerlebensdauer durch Anwendung einer Elektronenbestrahlung in vertikaler Bauelementrichtung homogen abgesenkt) der Teiltransistorverstärkungsfaktor αₚₙₚ gegenüber der herkömmlichen Dimensionierung stark erniedrigt, was wiederum die Sperrfähigkeit der vorgeschlagenen Struktur deutlich erhöht. Diesen Gewinn in der Sperrfähigkeit kann man dazu nutzen, die Bauelementdicke weiter zu reduzieren und so auch die Verlustleistung des Thyristors weiter zu senken.

Im folgenden wird das erfindungsgemäße Verfahren zum Herstellen eines erfindungsgemäßen Thyristors nach Fig. 1 mit dem Feldverlauf nach Fig. 2 erläutert.

In einem ersten Schritt von Verfahren zur Herstellung von Thyristoren werden eine erste Zone 1, die von einem ersten Leitfähigkeitstyp ist, eine zweite Zone 2, die von einem zweiten Leitfähigkeitstyp ist, der dem ersten Leitfähigkeitstyp entgegengesetzt ist, eine dritte Zone 3 von dem ersten Leitfähigkeitstyp und eine vierte Zone 4 von dem zweiten Leitfähigkeitstyp erzeugt. Die erste Zone 1 dient als Anode des Thyristors, die vierte Zone 4 dient als Kathode.

Bei den bisherigen Herstellungsverfahren wurde dazu ein Wafer verwendet. Bei dem erfindungsgemäßen Verfahren werden dagegen die erste Zone 1 und ein erster Abschnitt der zweite Zone 2 auf einem ersten Wafer 9 hergestellt, während die dritte Zone 3, die vierte Zone 4 sowie ein zweiter Abschnitt der zweiten Zone 2 auf einem zweiten Wafer 10 hergestellt werden. Zur Herstellung der beiden Zonen 1 sowie 3 und 4 wird vorzugsweise ein erster und zweiter, jeweils n⁻-dotierter Wafer 9 bzw. 10 verwendet. Auf einer äußeren Oberfläche 11 des Wafers 9 wird die erste Zone 1 erzeugt, auf einer äußeren Oberfläche 11 des Wafers 10 werden die beiden Zonen 3 und 4 erzeugt. Unter "äußerer" Oberfläche 11 wird hier und im folgenden eine Oberfläche verstanden, die auch nach dem Verbinden des Wafers frei zugänglich bleibt. Im Gegensatz dazu ist eine "innere" Oberfläche 12 eines Wafers eine Oberfläche, die nach dem Verbinden der beiden Wafer nicht mehr frei zugänglich ist. Der n⁻-dotierte Wafer 9 bzw. 10 bildet den ersten bzw. zweiten Abschnitt der späteren Basiszone 2 des Thyristors.

Nach den obigen Herstellungsschritten für den erfindungsgemäßen Thyristor hat man damit die vier Zonen des Thyristors auf zwei Wafern 9 und 10 und die Basiszone 2 des Thyristors ist in Form von zwei Abschnitten auf den beiden Wafern 9 und 10 vorhanden.

In einem folgenden Schritt des Herstellungsverfahrens wird nun auf einer inneren Oberfläche 12 des ersten Wafers 9 oder des zweiten Wafers 10 eine Feldstoppzone 8 erzeugt, indem man eine Schicht auf einer der beiden inneren Oberflächen 12 mit der für die Feldstoppzone erforderlichen Dosis n-dotiert. Als Atome kommen z.B. Phosphor, Schwefel oder Selen in Frage. Die Feldstoppzone 8 liegt also direkt an der inneren Oberfläche 12 eines der Wafer 9 oder 10. In Fig. 1 ist die Grenzfläche zwischen dem ersten Wafer 9 und dem zweiten Wafer 10 durch eine Verlängerung der oberen Seite der Feldstoppzone 8 dargestellt. Damit liegt die Feldstoppzone 8 in dem unteren Wafer 9. Es ist aber offensichtlich, daß die Feldstoppzone 8 genauso gut in dem oberen Wafer 10 hergestellt werden kann.

Anschließend verbindet man den ersten Wafer 9 und den zweiten Wafer 10 mittels der sogenannten Waferbonding-Technik miteinander, so daß die beiden inneren Oberflächen 12 der beiden Wafer 9 und 10 aufeinander liegen. Damit ist der Thyristor in seiner in Fig. 1 gezeigten Struktur fertiggestellt.

Die Feldstoppzone 8 kann insbesondere durch Ionenimplantation erzeugt werden. Um wie oben erwähnt ein Eindringen der Raumladungszone in die andere Hälfte der n⁻-Basis 2 zu verhindern und die Dotierung der Feldstoppzone 8 so einzustellen, daß sie hierzu gerade ausreicht wird bei der Herstellung des Bauelements eine Ionendosis von 10¹²cm⁻² bis 10¹³cm⁻² verwendet. Bei der Herstellung der Feldstoppzone 8 durch Ionenimplantation werden die implantierten Atome dann anschließend durch eine Temperaturbehandlung elektrisch aktiviert und eventuell eindiffundiert. Im allgemeinen findet hierbei auch eine gewissen Eindiffusion der implantierten Atome statt (z.B. in eine Tiefe von 10 µm).

## Patentansprüche

1. Symmetrischer Thyristor mit
einer ersten Zone (1) von einem ersten Leitfähigkeitstyp, die als Anode dient,
einer zweiten Zone (2) von einem zweiten Leitfähigkeitstyp, die als Basis dient,
einer dritten Zone (3) von dem ersten Leitfähigkeitstyp,
einer vierten Zone (4) von dem zweiten Leitfähigkeitstyp, die als Kathode dient,
wobei die erste (1) und die vierte (4) Zone höher dotiert sind als die zweite (2) bzw. dritte (3) Zone und mindestens eine Steuerelektrode (7) mit der dritten Zone (3) verbunden ist,
einer Feldstoppzone (8) von dem zweiten Leitfähigkeitstyp, die annähernd in der Mitte der zweiten Zone (2) angeordnet ist, so daß sie die zweite Zone (2) in zwei im wesentlichen gleich große Abschnitte unterteilt und die stärker als die zweite Zone dotiert ist,
**dadurch gekennzeichnet, daß** die Feldstoppzone so dotiert ist, daß ein Eindringen einer sich bei sperrend angesteuerten Thryristor ausbreitenden Raumladungszone von einer Hälfte der Basis (2) in eine andere Hälfte der Basis (2) verhindert wird.

2. Verfahren zum Herstellen eines Thyristors nach Anspruch 1 mit den Schritten:
Erzeugen einer ersten Zone (1) von einem ersten Leitfähigkeitstyp, die als Anode dient, Erzeugen einer zweiten Zone (2) von einem zweiten Leitfähigkeitstyp, die als Basis dient, Erzeugen einer dritten Zone (3) von dem ersten Leitfähigkeitstyp, und Erzeugen einer vierten Zone (4) von dem zweiten Leitfähigkeitstyp, die als Kathode dient, wobei
die erste Zone (1) und ein erster Abschnitt der zweiten Zone (2) auf einem ersten Wafer (9) erzeugt werden,
die dritte Zone (3) und die vierte Zone (4) sowie ein zweiter Abschnitt der zweiten Zone (2) auf einem zweiten Wafer (10) erzeugt werden,
eine Feldstoppschicht (8) in einem Bereich an einer inneren Oberfläche (12) des ersten Wafers (9) oder des zweiten Wafers (10) erzeugt wird und
der erste Wafer (9) mit dem zweiten Wafer (10) verbunden wird, so daß die beiden inneren Oberflächen (12) der beiden Wafer (9, 10) aufeinander liegen.

3. Verfahren nach Anspruch 2,
**dadurch gekennzeichnet, daß**
die Feldstoppzone (8) durch Ionenimplantation in eine Schicht in einem Bereich an einer inneren Oberfläche (12) eines der beiden Wafer (9, 10) erzeugt wird und die implantierten Atome durch eine nachfolgende Temperaturbehandlung elektrisch aktiviert und eventuell eindiffundiert werden.

4. Verfahren nach Anspruch 3,
**dadurch gekennzeichnet, daß**
die Ionenimplantation mit einer Ionendosis von 10¹²cm⁻² bis 10¹³cm⁻² erfolgt.

## Claims

1. Symmetrical thyristor having
a first zone (1) of a first conductivity type, which serves as an anode,
a second zone (2) of a second conductivity type, which serves as a base,
a third zone (3) of the first conductivity type,
a fourth zone (4) of the second conductivity type, which serves as a cathode,
the first (1) and the fourth (4) zones being doped more heavily than the second (2) and third (3) zones, respectively, and at least one control electrode (7) being connected to the third zone (3),
a field stop zone (8) of the second conductivity type, which is arranged approximately in the centre of the second zone (2), with the result that it subdivides the second zone (2) into two sections of essentially the same size, and which is doped more heavily than the second zone,
**characterized in that**
the field stop zone is doped in such a way as to prevent penetration of a space charge zone that propagates when the thyristor is driven in the off state from one half of the base (2) into another half of the base (2).

2. Method for producing a thyristor according to Claim 1 having the steps of:
producing a first zone (1) of a first conductivity type, which serves as an anode, producing a second zone (2) of a second conductivity type, which serves as a base, producing a third zone (3) of the first conductivity type, and producing a fourth zone (4) of the second conductivity type, which serves as a cathode,
the first zone (1) and a first section of the second zone (2) being produced on a first wafer (9),
the third zone (3) and the fourth zone (4) and also a second section of the second zone (2) being produced on a second wafer (10),
a field stop layer (8) being produced in a region at an inner surface (12) of the first wafer (9) or of the second wafer (10), and
the first wafer (9) being connected to the second wafer (10), such that the two inner surfaces (12) of the two wafers (9, 10) lie one on top of the other.

3. Method according to Claim 2,
**characterized in that**
the field stop zone (8) is produced by ion implantation into a layer in a region at an inner surface (12) of one of the two wafers (9, 10) and the implanted atoms are electrically activated and possibly indiffused by a subsequent thermal treatment.

4. Method according to Claim 3,
**characterized in that**
the ion implantation is carried out with an ion dose of from 10¹² cm⁻² to 10¹³ cm⁻².

## Revendications

1. Thyristor symétrique comprenant :
une première zone (1) d'un premier type de conductibilité servant d'anode ;
une deuxième zone (2) d'un deuxième type de conductibilité servant de base,
une troisième zone (3) du premier type de conductibilité servant de deuxième base,
une quatrième zone (4) du deuxième type de conductibilité servant de cathode,
la première (1) et la quatrième (4) zones étant dopées plus fortement que la deuxième (2) ou la troisième (3) zone et au moins une électrode de commande (7) étant reliée à la troisième zone (3), avec une zone d'arrêt de champ (8) du deuxième type de conductibilité approximativement au centre de la deuxième zone (2) pour ainsi diviser la deuxième zone (2) en deux segments pour l'essentiel de la même grandeur et qui est dopée plus fortement que la deuxième zone,
**caractérisé en ce que**
la zone d'arrêt de champ est dopée pour empêcher une pénétration d'une zone de charge d'espace se propageant, lorsque le thyristor est commandé en blocage, d'une moitié de la base (2) dans une autre moitié de la base (2).

2. Procédé de fabrication d'un thyristor selon la revendication 1, comprenant les étapes :
réalisation d'une première zone (1) d'un premier type de conductibilité qui sert d'anode,
réalisation d'une deuxième zone (2) d'un deuxième type de conductibilité qui sert de base,
réalisation d'une troisième zone (3) du premier type de conductibilité qui sert de deuxième base,
réalisation d'une quatrième zone (4) du deuxième type de conductibilité qui sert de cathode, la première zone (1) et un premier segment de la deuxième zone (2) étant réalisés sur une première plaquette (9), la troisième zone (3) et la quatrième zone (4) ainsi qu'un deuxième segment de la deuxième zone (2) étant réalisés sur une deuxième plaquette (10), avec une zone d'arrêt de champ (8) réalisée dans une région sur une surface intérieure (12) de la première plaquette (9) ou de la deuxième plaquette (10), et la première plaquette (9) étant reliée à la deuxième plaquette (10) afin que les deux surfaces intérieures (12) des deux plaquettes (9, 10) reposent l'une sur l'autre.

3. Procédé selon la revendication 2,
**caractérisé en ce que**
la zone d'arrêt de champ (8) est réalisée par implantation d'ions dans une couche dans une région sur une surface intérieure (12) d'une des deux plaquettes (9, 10), et les atomes implantés sont activés électriquement et éventuellement diffusés à l'intérieur par un traitement thermique ultérieur.

4. Procédé selon la revendication 3,
**caractérisé en ce que**
l'implantation d'ions s'effectue avec une dose d'ions entre 10¹²cm⁻² et 10¹³cm⁻².
